# EUROPEAN PATENT APPLICATION

(11) **EP 1 630 249 A2**
(43) Date of publication of application: **01.03.2006**
(21) Application number: 05018682.4
(22) Date of filing: 29.08.2005
(51) Int. Cl.: C23C 16/34

(54) **Process for chemical vapor deposition of silicon nitride.**

(30) Priority: 30.08.2004 US 929755
(71) Applicant: AIR PRODUCTS AND CHEMICALS, INC., Allentown, PA 18195-1501 (US)
(72) Inventor: Hochberg, Arthur Kenneth, Solana Beach CA 92075 (US); Cuthill, Kirk Scott, Vista CA 92084 (US)
(74) Representative: Teipel, Susanne

(57) **Abstract**

A process for the plasma enhanced chemical vapor deposition of silicon nitride films from nitrogen, argon, xenon, helium or ammonia and an aminosilane, preferably of the formula: (t-C₄H₉NH)₂SiH₂ that provides improved properties, particularly etch resistance and low hydrogen concentrations as well as stress control, of the resulting film for use in the semiconductor industry.

## Description

### BACKGROUND OF THE INVENTION

The present invention is directed to the field of plasma enhanced low pressure chemical vapor deposition of silicon nitride films using aminosilanes, a range of ammonia or a relatively inert gas to improve the etch resistance and reduce the hydrogen concentration of the deposited silicon nitride.

In the fabrication of semiconductor devices, a thin passive layer of a chemically inert dielectric material such as silicon nitride (Si₃N₄) is essential. Thin layers of silicon nitride function as diffusion masks, oxidation barriers, trench isolation, intermetallic dielectric material with high dielectric breakdown voltages and passivation layers. Many other applications of silicon nitride coatings in the fabrication of semiconductor devices are reported elsewhere, see Semiconductor and Process technology handbook, edited by Gary E. McGuire, Noyes Publication, New Jersey, (1988), pp 289-301; and Silicon Processing for the VLSI ERA, Wolf, Stanley, and Talbert, Richard N., Lattice Press, Sunset Beach, California (1990), pp 20-22, 327-330.

The present semiconductor industry standard silicon nitride growth method is by low pressure chemical vapor deposition ("LPCVD") in a hot wall reactor at >750°C using dichlorosilane and ammonia.

Deposition of silicon nitride over large numbers of silicon wafers has been accomplished using many precursors. The low pressure chemical vapor deposition using dichlorosilane and ammonia requires deposition temperatures greater than 750°C to obtain reasonable growth rates and uniformities. Higher deposition temperatures are typically employed to get the best film properties. There are several drawbacks in these processes and some of these are as follows:
i) Deposition under 850°C gives poor hazy films with chlorine and particle contamination;
ii) Silane and dichlorosilane are pyrophoric, toxic compressed gases;
iii) Films formed from dichlorosilane result in the formation of less uniform films; and
iv) Films from dichlorosilane have contaminants, such as chlorine and ammonium chloride, which are formed as byproducts.

Japanese Patent 6-132284 describes deposition of silicon nitride using organosilanes with a general formula (R₁R₂N)ₙ SiH₄₋ₙ ( where R₁ and R₂ range from H-, CH₃ -, C₂H₅- C₃H₇-, C₄H₉-) by a plasma enhanced chemical vapor deposition and thermal chemical vapor deposition in the presence of ammonia or nitrogen. The precursors described here are tertiary amines and do not contain NH bonding as in the case of the present invention. The deposition experiments were carried out in a single wafer reactor at 400°C at high pressures of 80-100 Torr. The Si:N ratios in these films were 0.9 (Si:N ratios in Si₃N₄ films is 0.75) with hydrogen content in the deposited films. The butyl radical is in the form of isobutyl.

Sorita et al., J. Electro.Chem. Soc. , Vol 141, No12, (1994), pp 3505-3511, describe deposition of silicon nitride using dichlorosilane and ammonia using a LPCVD process. The major products in this process are aminochlorosilane, silicon nitride and ammonium chloride. Formation of ammonium chloride is a major drawback of using Si-Cl containing precursors. The formation of ammonium chloride leads to particle formation and deposition of ammonium chloride at the backend of the tube and in the plumbing lines and the pumping system. Processes which contain chlorine in the precursors result in NH₄Cl formation. These processes require frequent cleaning and result in large down time of the reactors.

B. A. Scott, J. M. Martnez-Duart, D.B. Beach, T. N. Nguyen, R. D. Estes and R.G. Schad., Chemtronics, 1989, Vol 4, pp 230-234., report deposition of silicon nitride using silane and ammonia by PECVD in the temperature region of 250-400°C. Silane is a pyrophoric gas and is difficult to control for the deposition of clean silicon nitride due to partial gas phase reaction.

J. M. Grow, R. A. Levy, X. Fan and M. Bhaskaran, Materials Letters, 23, (1995), pp 187-193, describe deposition of silicon nitride using ditertiarybutylsilane and ammonia by LPCVD process in the temperature range of 600-700°C. The deposited silicon nitride films were contaminated with carbon impurities (10 atomic %). This is mainly due to the presence of direct Si-C bonds in the precursor.

A. K. Hochberg and D. L. O'Meara, Mat. Res. Soc. Symp. Proc,. Vol. 204, (1991), pp 509-514, report deposition of silicon nitride and silicon oxynitride by using diethylsilane with ammonia and nitric oxide by LPCVD. The deposition was carried out in the temperature range of 650°C to 700°C. The deposition is limited to deposition at 650°C and the deposition rate drops to below 4Å/min at lower temperatures. In the LPCVD process, precursors which contain direct Si-C carbon bonds result in carbon contamination in the films. Carbon free deposition requires greater than 5:1 NH₃ to precursor ratios. At lower ammonia concentrations, the films were found to contain carbon. Diethylsilane + ammonia processes typically require covered boats or temperature ramping to improve uniformities across the wafers.

US Patent 5,234,869 and R.G. Gordon and D. M. Hoffman, Chem. Mater., Vol. 2, (1990), pp 482-484 disclose other attempts to reduce the amount of carbon involved aminosilanes, such as tetrakis(dimethylamino)silane. The temperature of deposition is in the range of 300-1000°C with pressures in the range of 1 mTorr-10 Torr. The presence of direct Si-N bonds and the absence of Si-C bonds were expected to give lower carbon concentrations in the films. However, there are three main disadvantages with precursors of this class.
1) They contain N-methyl groups, the methyl groups tend to migrate to the silicon surface readily and contaminate the films with carbon during a CVD process. In order to reduce the amount of carbon, the process involves high temperatures (>700) and high ammonia ratios (>10:1). With increased ammonia ratios the deposition rates dramatically reduce due to reactant depletion.
2) They do not contain NH bonding and they do not involve secondary silanes.
3) At lower temperatures the deposition rates and uniformities are very poor (>5%).

US Patent 5,874,368 teaches the use of bis(tertiarybutylamino)silane as a precursor to deposit silicon nitride using low pressure chemical vapor deposition at a temperature range of 500° to 800° C. Ammonia, nitrogen and argon are considered for reaction atmospheres, with ammonia present at greater than 1:1 ratios of the aminosilane.

US Patent 6,268,299 is directed to silicon nitride depositions using LPCVD, but makes the statement at col. 5, lines34-35; "Thus, the conventional PECVD process used to deposit nitride barrier films has a number of inherent disadvantages."

US Patent 5,622,596 discloses at col. 3, lines 17-20 that silicon nitride stoichiometry can be related to silane and ammonia and nitrogen ratios in a plasma enhanced chemical vapor deposition ("PECVD") process.

US Patent 5,040,046 reports that diethylsilane with nitrogen-containing or oxygen-containing compounds can create dense silicon nitride or silicon oxide, respectively, under PECVD conditions.

The prior art has attempted to produce silicon nitride films at low temperatures, at high deposition rates and low hydrogen and carbon concentrations. The low hydrogen is required because
- Hydrogen migrates to the Si-SiO2 interface where it creates interface states (electrical instabilities)
- Hydrogen lowers film densities, thus increasing etch rates.
- Hydrogen decreases the thermal stability of deposited films.
- Film stresses change with hydrogen migration.

However, the prior art has not been successful in achieving all these goals simultaneously with a silicon nitride precursor. The present invention has overcome the problems of the prior art with the use of aminosilanes in a PECVD process for the formation of silicon nitride which avoids the problems of the prior art, operates at low thermal conditions, avoids Si-C bonds to reduce carbon contamination of the resulting films, has low hydrogen concentrations, as well as avoiding chlorine contamination and operates at low pressures (20 mTorr - 2 Torr) in a manufacturable system as will be described in greater detail below.

### BRIEF SUMMARY OF THE INVENTION

The present invention is a process for the plasma enhanced chemical vapor deposition of high density silicon nitride on a substrate using an aminosilane and a reactant selected from the group consisting of nitrogen, argon, xenon, helium and high ratios of ammonia in relation to the aminosilane.

### BRIEF DESCRIPTION OF THE DRAWINGS

Figure 1 is a graph of Si-N absorbance wavenumbers vs. flow ratio of additive (NH3, N2 or He) to aminosilane, BTBAS, under the conditions shown in the graph, where lower wavenumber equates to higher density.

Figure 2 is FTIR spectra of silicon nitride films grown by PECVD using BTBAS, under the conditions shown in the graph

Figure 3 is FTIR spectra of silicon nitride films grown by PECVD using BIPAS, bis(isopropylamino)silane, under the conditions shown in the graph.

Figure 4 shows film stresses related to different additives used to deposit PECVD films using BIPAS.

Figure 5 compares etch rates of LPCVD and PECVD films as descibed in the graph.

### DETAILED DESCRIPTION OF THE INVENTION

A large variety of "thin films" are used in the fabrication of Very Large Scale Integration (VLSI) devices. These deposited thin films can be of metals, semiconductors, or insulators. The films may be thermally grown or deposited from the vapor phase using LPCVD. VLSI technology requires very thin insulators for a variety of applications in both microprocessors and random-access memories device fabrication. Silicon dioxide has been predominantly used as a dielectric material because of its ease of deposition and excellent properties at the SiO₂/Si interface. Silicon nitride has other advantages over silicon dioxide, some of these include impurity and dopant resistant diffusion barriers, high dielectric breakdown voltages, superior mechanical and inherent inertness of Si₃N₄.

In VLSI fabrication a large set of rigorous chemical, structural, process and electrical requirements need to be satisfied. Purity of the film, thickness, uniformity and deposition rates are some of the strictly controlled parameters to facilitate fabrication of submicron features in a device. It is a major advantage in the fabrication and performance of a device if the deposition process can be carried out at temperatures lower than 500°C. A safe, reliable low temperature silicon nitride source material has applications in other technologies, such as; flat panel display devices, other electronic and non-electronic substrates or compound semiconductor device fabrication.

The present invention is directed to a class of aminosilanes that deposit silicon nitride at unexpectedly low temperatures with superior uniformities and high densities under plasma enhanced chemical vapor deposition when an ammonia reactant is increased or replaced with nitrogen, helium, argon or xenon.

The aminosilane can include those structures set forth in Table 1 below.

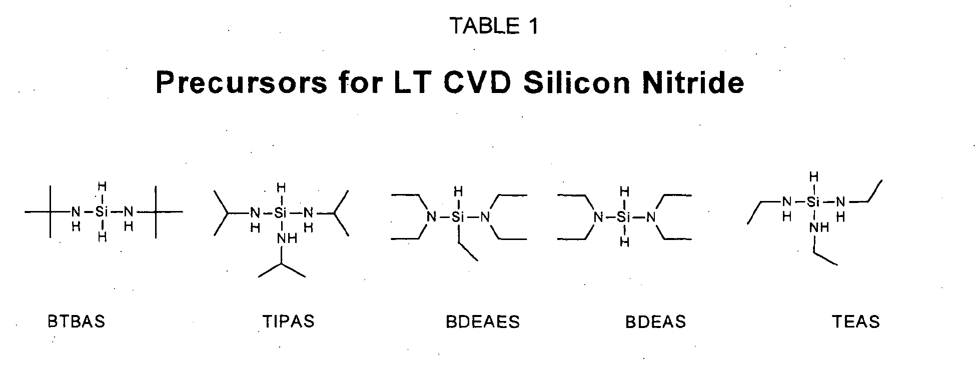

Where BTBAS = Bis(tertiarybutylamino)silane
TIPAS = Tris(isopropylamino)silane
BDEAES = Bis(diethylamino)ethylsilane
BDEAS = Bis(diethylamino)silane
TEAS = Tris(ethylamino)silane
or [(RₓNH₍₂₋ₓ₎]_{y}SiH_{(3-y)} where x= 1,2; y= 1,2,3; R=alkyl, aryl, arylalkyl, alkenyl or alkynyl.

The mono-, bis-, tris-, and tetrakis- structures are also included.

Bis(tertiarybutylamino)silane is particularly of interest and has the following formula:

(t-C₄H₉NH)₂Si(H)₂.

The deposited films have superior uniformities and are free of ammonium chloride and chlorine contamination. The bis(tertiarybutylamino)silane apparently has the property to deposit silicon nitride at 250-300°C below that of the dichlorosilane + ammonia process by LPCVD.

The advantage of aminosilanes, such as; bis(tertiarybutylamino)silane, may be attributable to the inherent property of the N-Si bond. The presence of the N-H bond may facilitate labile β-hydride transfer to form diaminosilane.

Other advantages of aminosilanes can be summarized as follows:
1) They are generally non-pyrophoric, volatile, stable liquids.
2) They do not have any chlorine in the precursor. The Si-Cl bonds in dichlorosilane leads to the formation of ammonium chloride, which deposits in the back end of the tube and requires frequent cleaning.
3) The precursors preferably do not contain direct Si-C bonds, and the resulting LPCVD silicon nitride films are carbon free, as indicated by auger spectroscopy.
4) The t-butyl amino ligands of bis(tertiarybutylamino)silane behave as good leaving groups to form isobutylene and are readily eliminated during pyrolysis. This is thought to be in part because the compound has a N-H bond. This additional advantage helps in removing all the carbon cleanly without contaminating the deposited films.
5) When compared to the dichlorosilane and ammonia process, aminosilane gives cleaner films at lower temperature.

To form silicon nitride films by PECVD, the bis(tertiarybutylamino)silane and ammonia are allowed to react in the plasma to form precursors that result in silicon nitride depositions on a wafer at a wafer temperature of less than 500°C (preferably 420°C, but the temperature could be less or greater than this range). Reaction may occur either on the surface or very close to the wafer surface to deposit a thin silicon nitride film. If the reaction occurs in the gas phase (a homogeneous reaction) then clusters of silicon nitride are formed. Such cases are typical in silane and ammonia process. When the reaction occurs on the wafer surface, then the resulting films are of superior quality. Thus, one important requirement for a PECVD application is the degree to which heterogeneous reactions are favored over gas phase reactions.

The PECVD process can be grouped into a) a gas-phase process and b) a surface reaction process. The gas phase phenomenon is the rate at which gases impinge on the substrate. This is modeled by the rate at which gases cross the boundary layer that separates the bulk regions of flowing gas and substrate surface. Such transport processes occur by gas-phase diffusion, which is proportional to the diffusivity of the gas and concentration gradient across the boundary layer. Several surface processes can be important when the gases reach the hot surface, but the surface reaction, in general, can be modeled by a thermally activated phenomenon which proceeds at a rate which is a function of the frequency factor, the activation energy, and the temperature.

The surface reaction rate increases with increasing temperature. For a given surface reaction, the temperature may rise high enough so that the reaction rate exceeds the rate at which reactant species arrive at the surface. In such cases, the reaction cannot proceed any more rapidly than the rate at which reactant gases are supplied to the substrate by mass transport. This is referred to as a mass-transport limited deposition process. At lower temperatures, the surface reaction rate is reduced, and eventually the concentration of reactants exceeds the rate at which they are consumed by the surface reaction process. Under such conditions the deposition rate is reaction rate limited. Thus, at high temperatures, the deposition is usually mass-transport limited, while at lower temperatures it is surface-reaction rate-limited. In actual processes, the temperature at which the deposition condition moves from one of these growth regimes to the other is dependent on the activation energy of the reaction, and the gas flow conditions in the reactor. Thus, it is difficult to extrapolate process conditions or results from one pressure regime or temperature regime to another.

In processes that are run under reaction rate-limited conditions, the temperature of the process is an important parameter. That is, uniform deposition rates throughout a reactor require conditions that maintain a constant reaction rate. This, in turn, implies that a constant temperature must exist everywhere on all wafer surfaces. On the other hand, under such conditions, the rate at which reactants reach the surface is not important, since their concentration does not limit the growth rate. Thus, it is not as critical that a reactor be designed to supply an equal flux of reactants to all locations of a wafer surface.

To induce the low pressure conditions in the reactor, an appropriate vacuum system is necessary. For the present experiments, the vacuum system consisted of a rotary vane pump/roots blower combination and various traps. The reactor pressure is controlled by a capacitance manometer feedback to a throttle valve controller. Reactor loading was through a load-lock such that the reaction chamber was kept under vacuum at all times.

The present invention of a method of depositing etch-resistant, low hydrogen silicon nitride films on silicon wafers by using a aminosilane precursor with increasing quantities of ammonia or replacing ammonia with nitrogen, argon, xenon or helium has been demonstrated experimentally.

### EXAMPLE 1:

Bis(tertiarybutylamino)silane is a non-pyrophoric volatile liquid which is safer to handle than silane and dichlorosilane. The deposition process is carried out at preferably 20mTorr-2Torr in the temperature range of 200 to 500°C, preferably 420°C, using vapors from bis(tertiarybutylamino)silane and ammonia. Preferably, an unreactive gas diluent, such as nitrogen, helium, xenon or argon, can be used to dilute or replace the ammonia in order to achieve extremely high density silicon nitride films. The molar feed ratio of ammonia to bis(tertiarybutylamino)silane is preferably in the range of 18:1 to 33:1

The process is performed in a cold wall PECVD reaction chamber. The process steps are as follows:
1. The susceptor is maintained at approximately 420 °C.
2. The silicon substrate is placed on the susceptor and sufficient time is given to reach the susceptor temperature.
3. Nitrogen or helium gas is introduced to the reaction chamber at 10 sccm.
4. Reaction chamber pressure is set to 1 Torr.
5. RF power density of 0.65 W/cm² is applied to the electrodes.
6. Ammonia and BTBAS are introduced to the reaction chamber at an ammonia :
   BTBAS flow ratio of greater than 5:1; preferably in the range of 18:1 to 33:1
7. Nitrogen, argon, xenon or helium may be used in place of ammonia in step 6.
8. The BTBAS vapor flow rate is approximately 11 sccm.
9. The BTBAS source temperature is 55 °C.
10. After the deposition, the substrate are removed through a loadlock and the film properties are measured.

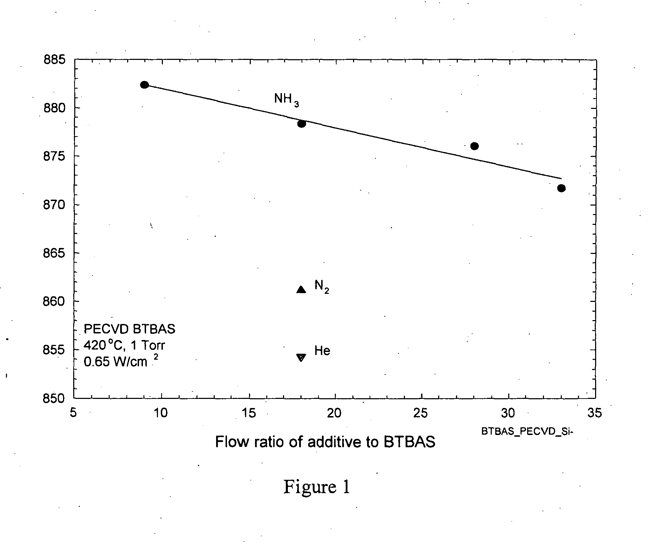

Figure 1 is a graph of Si-N absorbance wavenumbers vs. flow ratio of additive (NH3, N2 or He) to aminosilane, BTBAS, under the conditions shown in the graph, where lower wavenumber equates to higher density.

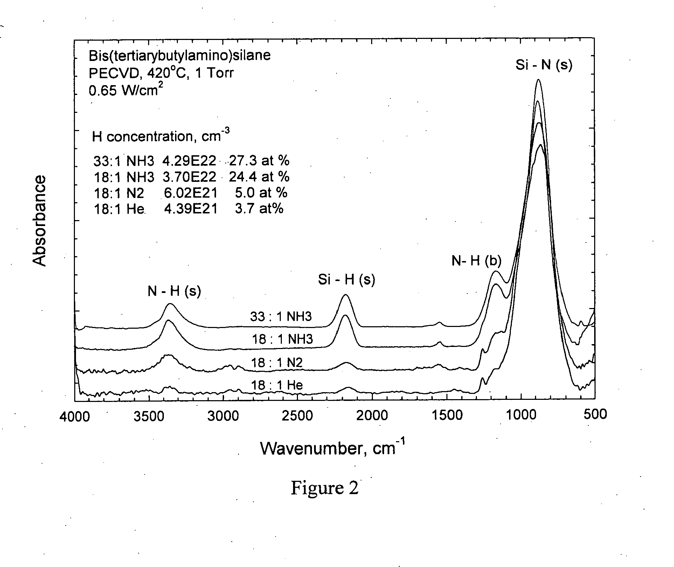

Figure 2 is FTIR spectra of silicon nitride films grown by PECVD using BTBAS, under the conditions shown in the graph

### EXAMPLE 2:

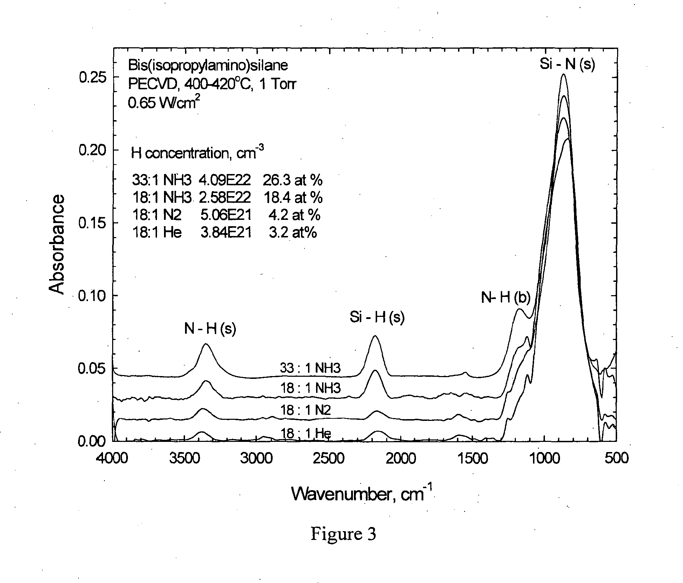

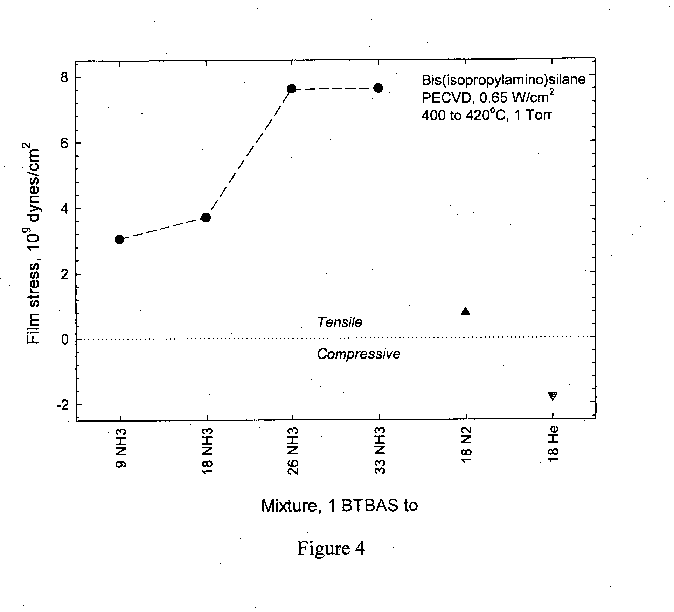

BIS(isopropylamino)silane is also non-pyrophoric volatile liquid which is safer to handle than silane and dichlorosilane. The process is identical to that in Example 1, except the precursor temperature is maintained at 40°C because of its higher vapor pressure than BTBAS. The results of the PECVD depositions are shown in Figure 3 under conditions given in the graph. For comparison of hydrogen concentrations, LPCVD films have approximately 3 atomic percent hydrogen. Figure 4 shows the film stress resulting from use of different additives. The stress may be modified by different combinations of additives.

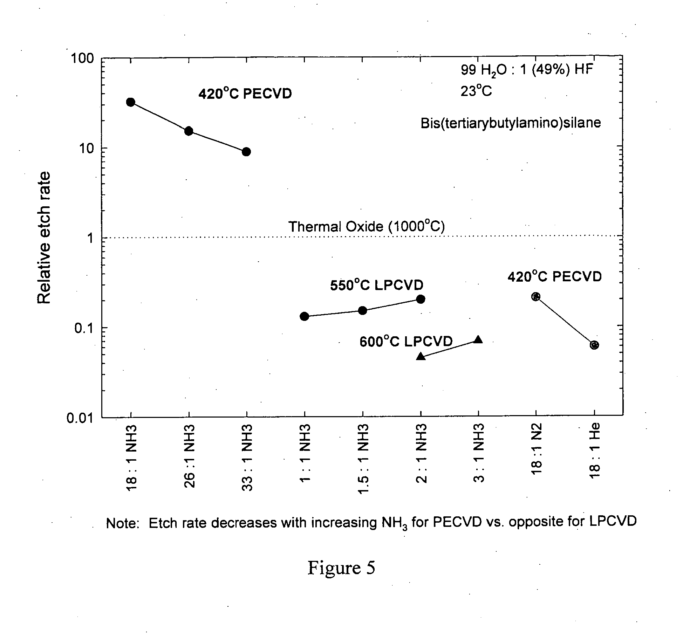

In general, silicon nitride etch resistance increases with ammonia flow contrary to LPCVD results (Figure 5). More etch resistant and lower hydrogen concentration films are obtained by replacing ammonia with nitrogen, Significant improvements are achieved, further, by using an inert gas in place of nitrogen. Having the nitrogen in the film coming only from the aminosilane shifts the Si-N absorption wavelength to lower wavenumbers, indicative of denser bonding. Also, in Figure 4 it is seen that PECVD films with nitrogen have the etch resistance of LPCVD films grown at much higher temperatures (550°C). Further, using an inert gas in place of nitrogen results in film etch resistances equivalent to 600°C LPCVD films. Although, the graph shows results for 1 % HF, similar results are obtained using buffered HF mixtures (Dil BOE) as shown in Table 2.

Etch rates are a measure of the film composition and density of the as deposited silicon nitride films. The data in Table 2 and Figure 5 demonstrates that the PECVD process of the present invention, using either increased ammonia reactant or replacing ammonia with an unreactive gas such as nitrogen or helium, and presumably, xenon or argon, results in very low etch rate silicon nitride films also. Such apparently high-density silicon nitride films with increased resistance to etch are highly desirable in the electronic device fabrication industry because silicon nitride is frequently used as an etch stop against metal and oxide films, so that differential etch rates facilitate fabrication of metal-oxide-semiconductor composites with appropriate patterning.

**TABLE 2**

| **Wafer #** | **Dep Type** | **Temp °C** | **Source** | **NH3 ratio** | **Relative Etch Rate 1% HF** | **Relative Etch Rate Dil BOE** |
|---|---|---|---|---|---|---|
| Thermal Ox#1 | Growth | 1000 | na | na | 1.00 | - |
| Thermal Ox#2 | Growth | 1000 | na | na | 1.00 | - |
| Thermal Ox#3 | Growth | 1000 | na | na | - | 1.00 |
| Thermal Ox#4 | Growth | 1000 | na | na | - | 1.00 |
| 1427-141C | PECVD | 420 | BTBAS | 18 | 31.99 | - |
| 1427-142C | PECVD | 420 | BTBAS | 26 | 15.12 | - |
| 1427-143C | PECVD | 420 | BTBAS | 33 | 8.84 | - |
| 1427-136 | PECVD | 420 | BTBAS | N2 | 0.21 | - |
| bipas-8 | PECVD | 420 | BIPAS | N2 | 0.23 | - |
| 1427-137 | PECVD | 420 | BTBAS | He | 0.06 | - |
| bipas-5 | PECVD | 420 | BIPAS | He | 0.06 | 0.04 |
| BTBAS-P5 | PECVD | 420 | BTBAS | He | - | 0.03 |
| bipas-11 | PECVD | 420 | BIPAS | He | - | 0.02 |
| BTBAS-P14 | PECVD | 375 | BTBAS | 50 | - | 4.44 |
| BTBAS-P25 | PECVD | 350 | BTBAS | 50 | - | 6.91 |
| BTBAS-P18 | PECVD | 350 | BTBAS | He | - | 0.07 |
| 2773N25 | LPCVD | 550 | BTBAS | 1 | 0.12 | - |
| 2776N25 | LPCVD | 550 | BTBAS | 1.5 | 0.15 | - |
| 2772N25 | LPCVD | 550 | BTBAS | 2 | 0.20 | - |
| ATV-130-02 | LPCVD | 570 | BTBAS | 2 | - | 0.07 |
| ATV-53-24 | LPCVD | 600 | BTBAS | 2 | 0.05 | 0.02 |
| ATV-36-24 | LPCVD | 600 | BTBAS | 3 | 0.07 | 0.03 |
| | | | | | | |

| | | | | | | |
|---|---|---|---|---|---|---|
| NOTE: Etch rate of thermal depositions increases with ammonia ratio, while increasing ammonia for PECVD decreases the etch rate. | | | | | | |

The present invention has been described with regard to a preferred embodiment, however the full scope of the present invention should be ascertained from the claims which follow.

## Claims

1. A process for decreasing the wet etch rate of plasma enhanced chemical vapor deposition silicon nitride on a substrate using a silicon precursor having at least one Si-N bond and a reagent selected from the group consisting of: (i) nitrogen; (ii) argon; (iii) xenon; (iv) helium; (v) mixtures of (ii), (iii) and/or (iv); (vi) ammonia and/or hydrazine; and (vii) the combination of an inert gas of (ii), (iii), (iv) or (v) with less than 1% ammonia in relation to the inert gas.

2. The process of Claim 1 wherein the silicon precursor has the formula:
(t-C₄H₉NH)₂SiH₂.

3. The process of Claim 1 wherein the temperature of the substrate is less than 800°C.

4. The process of Claim 1 wherein the temperature of the substrate is less than 500°C.

5. The process of Claim 1 wherein the pressure is at least approximately 1 mTorr.

6. The process of Claim 1 wherein the reagent is nitrogen.

7. The process of Claim 1 wherein the reactant is helium.

8. The process of Claim 1 wherein the reactant is ammonia and/or hydrazine.

9. The process of Claim 1 wherein the substrate is selected from the group consisting of silicon, silicon dioxide or a metal.

10. The process of Claim 1 wherein the substrate is an electronic device.

11. The process of Claim 1 wherein the substrate is a flat panel display.

12. A plasma enhanced chemical vapor deposition of low etch rate, low hydrogen content silicon nitride in a reaction zone, comprising the steps of:
a) heating a substrate to a temperature less than or equal to 800°C in said zone;
b) maintaining the substrate in a vacuum at a pressure at least approximately 1 mTorr in said zone;
c) introducing into said zone a silicon precursor of the formula:
(t-C₄H₉NH)₂SiH₂ and a reagent selected from the group consisting of (i) nitrogen; (ii) argon; (iii) xenon; (iv) helium; (v) mixtures of (ii), (iii) and/or (iv); (vi) ammonia and/or hydrazine; and (vii) the combination of an inert gas of (ii), (iii), (iv) or (v) with less than 1% ammonia in relation to the inert gas; and
d) maintaining the conditions of a) through c) sufficient to cause a film of low etch rate, low hydrogen content silicon nitride to deposit on the substrate.

13. A plasma enhanced chemical vapor deposition of high density silicon nitride in a reaction zone, comprising the steps of:
a) heating a substrate to a temperature less than or equal to 500°C in said zone;
b) maintaining the substrate in a vacuum at a pressure at least approximately 1 mTorr in said zone;
c) introducing into said zone a silicon precursor of the formula: (t-C₄H₉NH)₂SiH₂ and nitrogen; and
d) maintaining the conditions of a) through c) sufficient to cause a film of low etch rate, low hydrogen content silicon nitride to deposit on the substrate.

14. A plasma enhanced chemical vapor deposition of dense silicon nitride in a reaction zone, comprising the steps of:
a) heating a substrate to a temperature less than or equal to 500°C in said zone;
b) maintaining the substrate in a vacuum at a pressure at least approximately 1 mTorr in said zone;
c) introducing into said zone a silicon precursor of the formula: (t-C₄H₉NH)₂SiH₂ and helium; and
d) maintaining the conditions of a) through c) sufficient to cause a film of low etch rate, low hydrogen content silicon nitride to deposit on the substrate.

15. A plasma enhanced chemical vapor deposition of low etch rate, low hydrogen content silicon nitride in a reaction zone, comprising the steps of:
a) heating a substrate to a temperature less than or equal to 500°C in said zone;
b) maintaining the substrate in a vacuum at a pressure at least approximately 1 mTorr in said zone;
c) introducing into said zone a silicon precursor of the formula:
(t-C₄H₉NH)₂SiH₂ and an inert gas selected from the group consisting of: argon, xenon, helium and mixtures thereof; with less than 1% ammonia in relation to the inert gas; and
d) maintaining the conditions of a) through c) sufficient to cause a film of low etch rate, low hydrogen content silicon nitride to deposit on the substrate.

16. A process for producing a silicon nitride film of reduced etch rate on a substrate, comprising; conducting a plasma enhanced chemical vapor deposition of an aminosilane and a reagent selected from the group consisting of: (i) nitrogen; (ii) argon; (iii) xenon; (iv) helium; (v) mixtures of (ii), (iii) and/or (iv); (vi) ammonia and/or hydrazine; and (vii) the combination of an inert gas of (ii), (iii), (iv) or (v) with less than 1% ammonia in relation to the inert gas.

17. A process for producing a silicon nitride film of reduced etch rate using plasma enhanced chemical vapor deposition of low etch rate, low hydrogen content silicon nitride in a reaction zone, comprising the steps of:
a) heating a substrate to a temperature less than or equal to 500°C in said zone;
b) maintaining the substrate in a vacuum at a pressure in the range of approximately 20mTorr-2Torr in said zone;
c) introducing into said zone an aminosilane of the formula: [(RₓNH₍₂₋ₓ₎]_{y}SiH_{(3-y)} where x= 1,2; y= 1,2,3; R=alkyl, aryl, arylalkyl, alkenyl or alkynyl and a reagent selected from the group consisting of (i) nitrogen; (ii) argon; (iii) xenon; (iv) helium; (v) mixtures of (ii), (iii) and/or (iv); (vi) ammonia and/or hydrazine; and (vii) the combination of an inert gas of (ii), (iii), (iv) or (v) with less than 1% ammonia in relation to the inert gas; and
d) maintaining the conditions of a) through c) sufficient to cause a film of low etch rate, low hydrogen content silicon nitride to deposit on the substrate.

18. A process for the plasma enhanced chemical vapor deposition of low etch rate, low hydrogen content silicon nitride on a substrate using an aminosilane and a reactant selected from the group consisting of nitrogen, argon, xenon, helium and 18:1 to 33:1 ammonia in relation to the aminosilane.
